# EUROPEAN PATENT SPECIFICATION

(11) **EP 3 817 059 B1**
(45) Date of publication and mention of the grant of the patent: **09.12.2026**
(21) Application number: 20158773.0
(22) Date of filing: 21.02.2020
(51) Int. Cl.: H10K 59/131, H10K 50/844

(54) **DISPLAY COMPONENT, DISPLAY MODULE, MANUFACTURING METHODS AND ELECTRONIC DEVICE**
ANZEIGEKOMPONENTE, ANZEIGEMODUL, HERSTELLUNGSVERFAHREN UND ELEKTRONISCHE VORRICHTUNG
COMPOSANT D'AFFICHAGE, MODULE D'AFFICHAGE, PROCÉDÉS DE FABRICATION ET DISPOSITIF ÉLECTRONIQUE

(30) Priority: 30.10.2019 CN 201911042966
(43) Date of publication of application: 05.05.2021
(73) Proprietor: Beijing Xiaomi Mobile Software Co., Ltd., Beijing 100085 (CN)
(72) Inventor: ZHU, Xun, Beijing, 100085 (CN)
(74) Representative: Dehns Germany Partnerschaft mbB

(56) References cited:
- EP-A2- 2 806 475
- US-A1- 2014 138 637
- US-A1- 2018 046 221

## Description

### TECHNICAL FIELD

The present disclosure relates to the technical field of display, in particular to a display module, manufacturing methods and an electronic device.

### BACKGROUND

In daily life, electronic devices with display functions are applied more and more widely. With the development of display technology, more and more research has been conducted on bendable electronic devices.

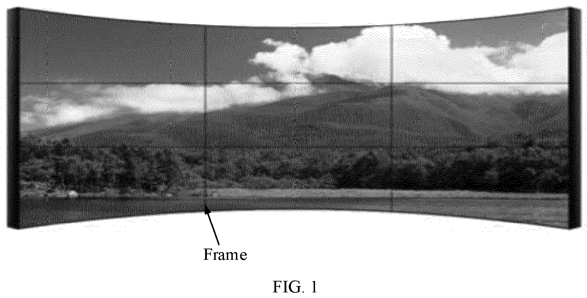

To make an electronic device bendable, as shown in FIG. 1, flat screens having specific shapes are often spliced in different areas of bent surfaces of the electronic device by a screen splicing method in the related art. However, such a method may form frames without a display function at the splicing seams between the adjacent flat screens, which degrades the display effect and user experience.

US2018/046221 A1 discloses a display component comprising a pixel array comprising a plurality of pixel units wherein adjacent pixel units are connected by a connecting structure configured to enable a distance between adjacent pixel units to be varied, and further configured to transmit a driving signal for driving the pixel units to emit light.
Further related prior art is disclosed in EP2806475 A2 and US2014138637 A1.

### SUMMARY

The invention is set out in the appended claims.

According to a first aspect of the present invention, a display module is provided, as described in claim 1. Advantageous embodiments are the subject matter of claims 2-6.

According to a second aspect of the present invention, a method of manufacturing a display module is provided, as described in claim 7. Advantageous embodiments are the subject matter of claims 8-9.

According to a third aspect of the present invention, an electronic device is provided, as described in claim 10. An advantageous embodiment is the subject matter of claim 11.

The technical solutions provided by the present invention may include the beneficial effects as follows.

According to the present invention, as defined in claim 1, a deformation extent of a first area of the display component is greater than that of a second area of the display component, wherein a first number of adjacent pixel units are encapsulated in the same encapsulation layer in the first area of the display component, and a second number of adjacent pixel units are encapsulated in the same encapsulation layer in the second area of the display component, the first number being less than the second number. Hereby, the minimum size of the encapsulation layer required to be etched and formed is increased, reducing the process difficulty, and decreasing the cost of the display component, compared with independent encapsulation of each pixel unit.

It is to be understood that the above general description and the following detailed description are merely exemplary and explanatory, and should not limit the present disclosure.

### BRIEF DESCRIPTION OF THE DRAWINGS

The accompanying drawings, which are incorporated in and constitute a part of this specification, illustrate embodiments consistent with the disclosure and, together with the description, serve to explain the principles of the invention.
FIG. 1 is a schematic diagram illustrating a display screen in the prior art.
FIG. 2A and FIG. 2B are partial schematic diagrams illustrating a display component according to an exemplary embodiment.
FIG. 3 is a partial schematic diagram illustrating another display component according to an exemplary embodiment.
FIG. 4A and FIG. 4B are partial schematic diagrams illustrating another display component according to an exemplary embodiment.
FIG. 5A and FIG. 5B are partial schematic diagrams illustrating another display component according to an exemplary embodiment.
FIG. 6 is a partial schematic diagram illustrating a display module according to an exemplary embodiment.
FIG. 7 is a flow chart illustrating a method of manufacturing a display component according to an exemplary embodiment.
FIG. 8 is a flow chart illustrating a method of manufacturing a display module according to an exemplary embodiment.
FIG. 9 is a schematic diagram illustrating an electronic device according to an exemplary embodiment.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the present disclosure. Instead, they are merely examples of apparatuses and methods consistent with aspects related to the present disclosure as recited in the appended claims.

In the related art, a method as shown in FIG. 1 is generally used to make a bendable electronic device, unbendable flat screens are often spliced in different areas of bent surfaces of the electronic device. However, this method may form frames without a display function at the splicing seams between adjacent flat screens, which may degrade the display effect and user experience. In the related art, it has not yet appeared such a method that a bendable electronic device is manufactured by making a bent surface of the electronic device to be covered with a bendable flexible screen.

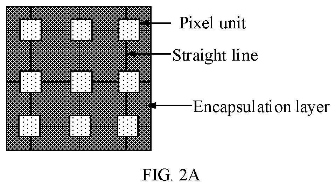

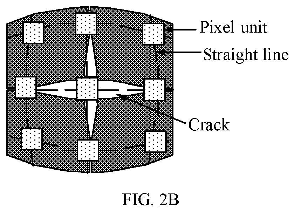

FIG. 2A is a partial schematic diagram of a display component without being stretched in the related art, and FIG. 2B illustrates a schematic diagram when the display component in FIG. 2A is stretched in multiple directions. Adjacent pixel units are connected by a connecting line, and the connecting line is configured to transmit a driving signal for driving the pixel units to emit light. In practical applications, to reduce the area of a Printed Circuit Board (PCB) occupied by the connecting line, the connecting line is often a straight line. Generally, the connecting line is not deformed, such as expanded or contracted, under the action of external force.

With reference to FIG. 2A and FIG. 2B, when the display component is subjected to acting forces from multiple directions, the display component may be deformed towards the multiple directions of the acting force, and the distance between the pixel units disposed in the deformation area may change.

When the display component is deformed in multiple directions, taking the pixel unit disposed at the center as an example, the distance between the pixel unit and the adjacent pixel unit may increase. The connecting line between the pixel unit and the adjacent pixel unit may not deform, therefore, when the distance between the pixel unit and the adjacent pixel unit increases, the connecting line may be subjected to a stretching acting force. Furthermore, in a case that the stretching acting force is beyond the range that the connecting line can withstand, the connecting line may be caused to break, and the connecting line between the pixel unit disposed at the center and the adjacent pixel unit may break. That is, the pixel unit disposed in the center cannot receive the driving signal, and the pixel unit may fail.

Moreover, when the display component is deformed in multiple directions, the distances between eight pixel units surrounding the center pixel unit may also increase, and the connecting lines between the pixel units also may break. As a result, all the pixel units in the area may fail.

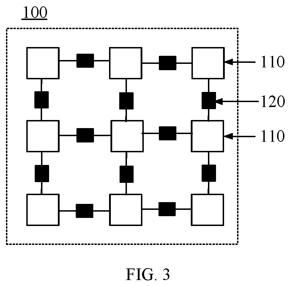

FIG. 3 is a schematic diagram illustrating a display component 100 according to an exemplary embodiment. Referring to FIG. 3, the display component 100 includes: a pixel array including a plurality of pixel units 110. Two adjacent pixel units 110 are connected by a connecting structure 120. The connecting structure 120 is configured to enable a distance between the two adjacent pixel units 110 to be increased or decreased to a required connection length when the pixel array is bent, and is further configured to transmit a driving signal for driving the pixel units 110 to emit light.

The display component 100 may include any component having a display function, for example, a display screen of a mobile terminal, a display surface of a wearable device, and the like.

The pixel unit 110 may include a Light-Emitting Diode (LED) or an Organic Light-Emitting Diode (OLED), for example, a Micro-LED and an Active-Matrix Organic Light-Emitting Diode (AMOLED).

The connecting structure 120 includes a structure capable of being stretched, and is configured to provide a connection length required for an increased distance between the pixel units 110 when the pixel array is bent, or provide a connection length required for a decreased distance when the pixel array is bent. It can be understood that when the distance between adjacent pixel units 110 in the pixel array decreases, the connecting structure 120 may contract. A gap may exist between the adjacent different connecting structures 120, which may reduce the rate of display errors of the display component 100 caused by contact between the different connecting structures 120, thereby ensuring the user experience.

The constituent materials of the connecting structure 120 may include: conductive rubber, conductive metal, and the like.

In an example, the connecting structure 120 may include an elastic straight-line segment, or a curved connecting line. The curved connecting line may further include an elastic connecting line.

For example, the connecting structure 120 includes an elastic straight-line segment. In a case that the pixel array is bent and that the distance between two pixel units connected by the elastic straight-line segment needs to be increased, the elastic straight-line segment can be stretched to provide a connection length required for the increased distance between the adjacent pixel units 110. In such a case, the elastic straight-line segment may be stretched to become a curved-line segment.

In a case that the pixel array is bent and that the distance between two pixel units connected by the elastic straight-line segment needs to be decreased, the elastic straight-line segment can contract to a required connection length to allow the decrease of distance between the two pixel units connected by the elastic straight-line segment.

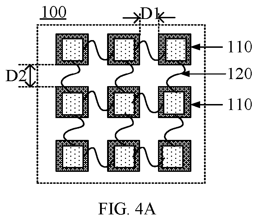

For another example, the connecting structure 120 includes a curved connecting line. Referring to FIG. 4A, in a case that the display component 100 does not deform, the curved connecting line may be disposed at a gap between two adjacent pixel units 110.

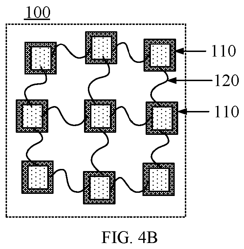

Referring to FIG. 4B, it is assumed that when the display component 100 is deformed, the pixel unit 110 disposed at the center is the highest point of the curved surface formed after the deformation, and the rest eight pixel units 110 surrounding the pixel unit 110 at the center are arranged radially around. When the distance between two adjacent pixel units 110 increases, the curved connecting line connecting the adjacent two pixel units 110 may be stretched, and the shape of the curved connecting line may be caused to change. In such a case, the curved connecting line provides the connection length required to increase the distance between the adjacent pixel units, that is, the curved connecting line after the shape change can still connect the two adjacent pixel units 110, and still guarantee that the display component 100 can work normally. Here, the deformation of the display component 100 may include bending, stretching, and the like. It can be understood that when the shape of the curved connecting line changes, the length of the curved connecting line may not change.

In a case that the pixel units are bent and that the distance between the adjacent pixel units decreases, the curved connecting line may contract to a required connection length between the adjacent pixel units. In such a case, the curved connecting line may become a more curved connecting line. It can be understood that the length of the curved connecting line can be unchanged.

In practical applications, the amount of change in the distance between two adjacent pixel units 110 can be calculated by simulation according to the amount of deformation required by the display component 100. Further, the length of the connecting structure 120 can be set according to the distance between two adjacent pixel units 110, or a material, which can have a deformation to an extent greater than the amount of change in the distance, may be selected to make the connecting structure 120.

In an example, when the display component 100 needs to achieve a stretch rate of 5%-10%, that is, when the area of the display component 100 where stretch occurs needs to be increased by 5%-10%, the amount of change in the distance between two adjacent pixel units in the stretched area may be calculated by simulation. In such a case, the length of the curved connecting line for connecting the two adjacent pixel units may be greater than the sum of the distance between the adjacent two pixel units when stretching occurs and the amount of change in the distance when the stretching occurs.

In an example, the length of the curved connecting line may be a predetermined multiple of the distance between the two adjacent pixel units 110.

Here, the distance between two adjacent pixel units 110 may be the distance between two adjacent pixel units 110 before the display component 100 is deformed. For example, the length of the curved connecting line may be twice the distance between two adjacent pixel units 110.

Specifically, referring to FIG. 4A, the length of a curved connecting line for connecting two horizontally arranged adjacent pixel units 110 may be twice the distance D1 between the horizontally arranged adjacent two pixel units. The length of a curved connecting line for connecting two vertically arranged adjacent pixel units may be twice the distance D2 between the two vertically arranged adjacent pixel units. The distance D1 and the distance D2 may be the same.

In practical applications, if the length of the curved connecting line is too long, the possibility of contact between the adjacent curved connecting lines may increase, and the cost of the display component 100 may increase. Therefore, by making a reasonable layout on the flexible substrate to form a curved connecting line with a predetermined multiple of the distance between two adjacent pixel units 110, it is possible to ensure that the display component 100 has flexibility, and at the same time, the probability of the display component 100 displaying errors due to contact between the different curved connecting lines can be reduced, and the user experience can be ensured.

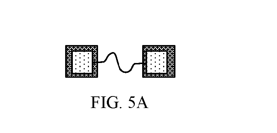

Referring to FIG. 5A, the curved connecting line may include one or more sequentially connected S-shaped line segments.

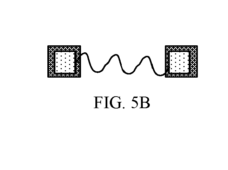

Or, referring to FIG. 5B, the curved connecting line may be a wavy line.

It can be understood that when the shape of the curved connecting line changes, the change may include that an S-shaped line segment is stretched to become a curved line segment with a smaller bending radian or become a straight line, or a wavy line is stretched to become a curved line with a smaller distance between a crest and an adjacent trough.

The material of the curved connecting line may include metal or alloy having a certain ductility, for example, aluminum, copper, and the like.

In the embodiments of the present disclosure, two adjacent pixel units 110 may be connected by the curved connecting line. When the display component 100 is subjected to acting force in multiple directions and is deformed, the curved connecting line may change in shape to allow relative displacement between adjacent pixel units 110 in the pixel array, so that the display component 100 can deform in multiple directions. Compared with connecting two adjacent pixel units by a straight line, the technical solution provided by the embodiments of the present disclosure can reduce the probability of the connecting lines for connecting the pixel units being broken when the display component is deformed, and improve the flexibility of the display component.

In some embodiments, the display component 100 may further include a flexible substrate. Furthermore, the display component comprises encapsulation layers.

The flexible substrate may be configured to bear the pixel array. The pixel units 110 may be disposed between the flexible substrate and the encapsulation layers.

The encapsulation layers are configured to protect the pixel units 110. Different pixel units 110 have the encapsulation layers independent of each other.

The constituent materials of the flexible substrate may include: stainless steel sheets, polymer, and the like, for example, polyimide, Polyethylene glycol terephthalate (PET), Polycarbonate (PC), Polystyrene (PS), Polypropylene (PP), and the like. The use of the flexible substrate is beneficial to improve the flexibility of the display component 100 and reduce the probability of damage to the display component 100 when deformation occurs.

The encapsulation layer may include a single-layer thin film or a multilayer thin film structure. For example, in a case that the encapsulation layer has a multi-layer thin film structure, the encapsulation layer may be formed by a structure in which an organic thin film layer and an inorganic thin film layer are stacked by Thin Film Encapsulation (TFE). The inorganic thin film layer may be made of at least one of aluminum oxide (Al₂O₃), silicon dioxide (SiO₂), magnesium oxide (MgO), or magnesium fluoride (MgF₂). The organic thin film layer may be made of at least one of Tetrafluoroethylene (TFE), Polymethyl-Methacrylate (PMMA), polyimide, PET, PC, PS, or PP. It can be understood that the encapsulation layer formed by adopting the above materials needs to ensure the light transmittance of the pixel unit.

Since different pixel units have independent encapsulation layers, when the display component is deformed, the deformation of the encapsulation layers of the individually encapsulated pixel units can be less or no deformation may occur. Therefore, the force applied to the encapsulation layer when the display component is deformed may be reduced, and further the probability of the encapsulation layer being damaged may be reduced.

In an example, independent encapsulation of each pixel unit may increase the cost of the display component. According to the invention, the deformation extent of a first area of the display component is greater than that of a second area of the display component, a first number of adjacent pixel units are encapsulated in the same encapsulation layer in the first area of the display component, and a second number of adjacent pixel units are encapsulated in the same encapsulation layer in the second area of the display component. The first number is less than the second number.

Specifically, simulation is performed according to a first maximum deformation extent to be implemented in the first area and a second maximum deformation extent to be implemented in the second area, and the amount of change in the distance between adjacent pixel units in the first area and the second area is calculated respectively. Further, adjacent pixel units with the amount of change in the distance greater than a distance threshold are encapsulated in different encapsulation layers, and adjacent pixel units with the amount of change in the distance less than the distance threshold are encapsulated in the same encapsulation layer, thereby increasing the minimum size of the encapsulation layer required to be etched and formed, and reducing the process difficulty.

For example, each pixel unit is individually encapsulated in the first area, while in the second area, four adjacent pixel units that make up a square shape are encapsulated in the same encapsulation layer. That is, the first number may be one and the second number may be four.

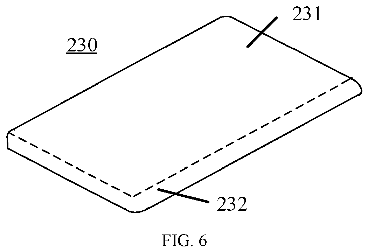

FIG. 6 is a schematic diagram illustrating a display module 230 provided by an exemplary embodiment. Referring to FIG. 6, the display module 230 includes a flat display area 231 and a curved display area 232. The display component forming the curved display area 232 is the display component 100 provided by the embodiments of the present disclosure.

The display module 230 may include a display screen provided with both a flat display area 231 and a curved display area 232.

In practical applications, the flat display area and curved display area of the display module may be set according to the application scenario of the display module. For example, in a case that the display module is applied to the surface of an electronic device, the flat display area may be configured to cover the flat area of the electronic device, and the curved display area may be configured to cover the cambered surface of the electronic device. The connecting line between adjacent pixel units in the flat display area 231 may be a straight line.

It can be understood that, in a case that the distance between two adjacent pixel units is the same, the cost of manufacturing a straight connecting line may be lower than the cost of manufacturing a curved connecting line. Therefore, in the embodiments of the present disclosure, the cost of manufacturing the display module can be reduced by setting the connecting lines between adjacent pixel units as curved connecting lines in the curved display area and keeping the connecting lines in the flat display area as straight lines.

In an example, the substrate of the curved display area 232 may be a flexible substrate, and the substrate of the flat display area 231 may be a hard substrate; or, the substrates of the flat display area 231 and the curved display area 232 may be both flexible substrates.

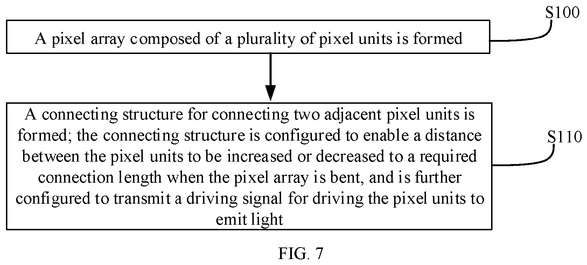

FIG. 7 is a schematic diagram illustrating a method of manufacturing a display component according to an exemplary embodiment. The method of manufacturing the display component is configured to manufacture the display component 100 according to the embodiments of the present disclosure, and the method of manufacturing the display component includes:
in S100, a pixel array including a plurality of pixel units is formed; and
in S110, a connecting structure for connecting two adjacent pixel units is formed; the connecting structure is configured to enable a distance between the pixel units to be increased or decreased to a required connection length when the pixel array is bent, and is further configured to transmit a driving signal for driving the pixel units to emit light.

Furthermore, two adjacent pixel units may be connected by the connecting structure. When the display component is bent, the connecting structure may enable a distance between the pixel units to be increased or decreased to a required connection length to allow relative displacement between every adjacent two pixel units in the pixel array, so that the display component can be bent in multiple directions, the probability of the connecting line for connecting the pixel unit being broken when the display component is bent can be reduced, and the flexibility of the display component can be improved.

In some embodiments, the method of manufacturing the display component may further include:
a barrier layer that covers the pixel array and the connecting structure is formed; and
the barrier layer is etched according to a preset pattern to form encapsulation layers, and different pixel units are provided with the encapsulation layers independent of each other.

It can be understood that the material of the barrier layer is the same as that of the encapsulation layer. After the barrier layer is etched, independent encapsulation layers corresponding to different pixel units may be formed.

In practical applications, the extent of deformation occurring in different areas of the display component may be different. Therefore, the amount of change in the distance between adjacent pixel units in different areas of the display component may be calculated by simulation. Further, the preset pattern may be designed according to the simulation result, adjacent pixel units with the amount of change in the distance greater than a distance threshold may be encapsulated in different encapsulation layers, and adjacent pixel units with the amount of change in the distance less than the distance threshold may be encapsulated in the same encapsulation layer, thereby increasing the minimum size of the encapsulation layer required to be etched and formed, and reducing the process difficulty.

In some embodiments, S100 may include that: the pixel array including a plurality of organic light-emitting diodes is formed.

Compared with a pixel array formed by Light-Emitting Diodes (LED), a pixel array formed by Organic Light-Emitting Diodes (OLED) can be thinner, can have better curvature, and can be more flexible.

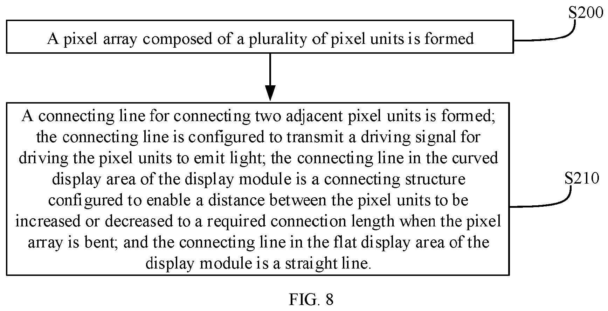

FIG. 8 shows a method of manufacturing a display module according to an exemplary embodiment. The method of manufacturing the display module is configured to manufacture the display module provided by the embodiments of the present disclosure. Referring to FIG. 8, the method of manufacturing the display module includes:
in S200, a pixel array including a plurality of pixel units is formed; and
in S210, a connecting line for connecting two adjacent pixel units is formed; the connecting line is configured to transmit a driving signal for driving the pixel units to emit light; the connecting line in the curved display area of the display module is a connecting structure configured to enable a distance between the pixel units to be increased or decreased to a required connection length when the pixel array is bent; and the connecting line in the flat display area of the display module is a straight line.

In the embodiments of the present disclosure, the cost of manufacturing the display module can be reduced by setting the connecting lines between adjacent pixel units as curved connecting lines in the curved display area and keeping the connecting lines in the flat display area as straight lines.

In some embodiments, the method of manufacturing the display module may further include that:
a barrier layer that covers the pixel array, the straight line and the connecting structure is formed; and
the barrier layer is etched according to a preset pattern to form a uniform encapsulation layer of the flat display area, and independent encapsulation layers of the pixel units are formed in the curved display area.

In an example, in the process of etching the barrier layer, two light shields with different preset patterns may be used to separately etch a portion of the barrier layer that covers the flat display area and a portion of the barrier layer that covers the curved display area.

Or, in the process of etching the barrier layer, the barrier layer may be etched by using the same light shield with different preset patterns in different areas, and the same encapsulation layer of the flat display area and the independent encapsulation layer of each pixel unit in the curved display area may be formed. In this way, process steps may be reduced and production efficiency may be improved.

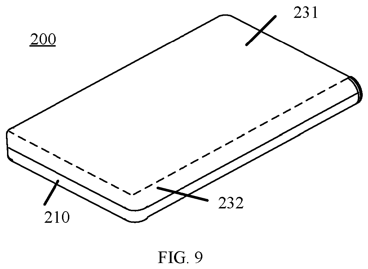

FIG. 9 is a schematic diagram illustrating an electronic device 200 according to an exemplary embodiment. Referring to FIG. 9, the electronic device 200 includes: a casing 210, a processing module (not shown) and the display module 230 provided by the embodiments of the present disclosure.

The processing module may be disposed in the casing 210 and may be configured to generate a driving signal.

The display module 230 may be configured to perform displaying according to the driving signal.

The electronic device 200 may include a fixed terminal and a mobile terminal, for example, a desktop computer, a television, a mobile phone, a wearable device, a tablet computer, and the like.

The processing module is generally configured to control overall operations of the electronic device 200, such as operations associated with display, telephone calls, data communication and camera operation. The processing module may include one or more processors to execute instructions to generate the driving signals. In addition, the processing module may further include one or more modules to facilitate interaction between the processing module and other components. For example, the processing module may include a multimedia module to facilitate interaction between multimedia components.

In an example, the flat display area 231 may include a display area disposed on a first surface the electronic device 200. The curved display area 232 may include: a display area disposed on a second surface of the electronic device 200. The second surface may be an adjacent surface of the first surface and the second surface may be a cambered surface.

The flat display area 231 and the curved display area 232 of the display module may be in contact with each other for performing display together based on driving signals. The connecting line between two adjacent pixel units in the flat display area 231 of the display module may be a straight line.

With the development of electronic device technology, users' demand for the ratio of a screen to a device has gradually increased. To increase the screen ratio, electronic device manufacturers often set up pop-up cameras or under-screen cameras to address the screen defects such as "fringes" and "beauty tips" on the display panels of electronic devices.

However, even if the camera does not occupy the position of the display panel, since the electronic device has multiple surfaces, there is a corner between adjacent surfaces, for example, a rounded corner between a display panel and a side frame of a casing of a mobile phone. In the full-screen technology, the display area of a cambered area covering the electronic device casing can be stretched.

In a case that the display module provided in the related art is stretched, since the connecting line between the pixel units is a straight line, the display module can be stretched in one direction only, and cannot be stretched in multiple directions at the same time. In a case that the display module in the related art is stretched in multiple directions at the same time, the connecting line between adjacent pixel units in the display module or the encapsulation of the display module may be damaged, causing the display module to fail. That is, the display module in the related art cannot cover a cambered surface like a spherical surface, and cannot realize full-screen display.

Compared with the related art, the electronic device 200 provided in the embodiments of the present disclosure uses the display component 100 as the curved display area 232 required to be stretched in the display module 230, so that the curved display area 232 of the display module 230 can be stretched in multiple directions at the same time, which lays a foundation for the realization of the full-screen display technology.

It can be understood that, the cost of manufacturing the display component 100 is higher than that of the flat display area 231, therefore, in the embodiments of the present disclosure, the display component 100 is only used as the curved display area 232 needed to be stretched. The display component 100 has high compatibility with the prior art, and on the basis of increasing the coverage area of the display area and achieving a full-screen display effect, the display component 100 can reduce the increase in the cost of manufacturing the electronic device 200.

It is intended that the specification and embodiments be considered as exemplary only, with the true of the present disclosure being indicated by the following claims.

## Claims

1. A display module (230), comprising:
a flat display area (231) and a curved display area (232);
wherein a display component (100) constituting the curved display area (232) comprises a pixel array comprising a plurality of pixel units, wherein every two adjacent pixel units (110) are connected by a connecting structure (120); and the connecting structure (120) is configured to enable a distance between the every two adjacent pixel units (110) to be increased or decreased to a required connection length when the pixel array is bent and is further configured to transmit a driving signal for driving the pixel units to emit light,
the flat display area (231) comprises a pixel array comprising a plurality of pixel units, wherein a connecting line for connecting every two adjacent pixels units (110) in the flat display area (231) is provided as a straight line, and is further configured to transmit a driving signal for driving the pixel units to emit light, and
the display module further comprises encapsulation layers configured to protect the pixel units,
**characterized in that**,
the display component comprises a first area and a second area, the first area having a greater deformation extent than the second area,
wherein a first number of adjacent pixel units are encapsulated in a same encapsulation layer in the first area, and a second number of adjacent pixel units are encapsulated in a same encapsulation layer in the second area,
wherein the first number is less than the second number.

2. The display module (230) of claim 1, wherein
the connecting structure (120) is an elastic straight-line segment; or,
the connecting structure (120) is a curved connecting line.

3. The display module (230) of claim 2, wherein
the curved connecting line comprises one or more sequentially connected S-shaped line segments; or,
the curved connecting line is a wavy line.

4. The display module (230) of claim 2 or 3, wherein a length of the curved connecting line is a predetermined multiple of the distance between the every two adjacent pixel units (110).

5. The display module (230) of any one of claims 1-4, further comprising a flexible substrate;
the flexible substrate is configured to bear the pixel array, wherein the pixel units are disposed between the flexible substrate and the encapsulation layers.

6. The display module (230) of any one of claims 1-5, wherein
a substrate of the curved display area is a flexible substrate, and a substrate of the flat display area is a hard substrate; or,
substrates of the flat display area and the curved display area are both flexible substrates.

7. A method of manufacturing the display module according to any one of claims 1-6, the method comprises:
forming (S100) a pixel array including a plurality of pixel units;
forming encapsulation layers of the plurality of pixel units in the curved display area; and
forming (S110) a connecting line for connecting every two adjacent pixel units; wherein the connecting line is configured to transmit a driving signal for driving the pixel units to emit light; the connecting line in the curved display area of the display module is the connecting structure configured to enable the distance between the every two pixel units to be increased or decreased to the required connection length when the pixel array is bent; and the connecting line in the flat display area of the display module is a straight line,
**characterized in that**,
forming the encapsulation layers of the plurality of pixel units in the curved display area comprises:
encapsulating a first number of adjacent pixel units of the display component in a same encapsulation layer in a first area, and encapsulating a second number of adjacent pixel units of the display component in a same encapsulation layer in a second area, the first area having a greater deformation extent than the second area, the first number being less than the second number.

8. The method of claim 7, further comprising:
forming a barrier layer that covers the pixel array, the straight line and the connecting structure; and
etching the barrier layer according to a preset pattern to form a uniform encapsulation layer of the flat display area.

9. The method of claim 7 or 8, wherein forming the pixel array including the plurality of pixel units comprises:
forming the pixel array comprising a plurality of organic light-emitting diodes.

10. An electronic device (200), comprising a casing, a processing module, and the display module according to any one of claims 1-6;
the processing module is disposed in the casing and is configured to generate a driving signal; and
the display module is configured to perform displaying according to the driving signal.

11. The electronic device of claim 10, wherein
the flat display area of the display module comprises a display area disposed on a first surface of the electronic device; and
the curved display area of the display module comprises a display area disposed on a second surface of the electronic device, wherein the second surface is an adjacent surface of the first surface and the second surface is a cambered surface.

## Patentansprüche

1. Ein Anzeigemodul (230), umfassend:
eine flache Anzeigefläche (231) und eine gekrümmte Anzeigefläche (232);
wobei eine Anzeigekomponente (100), die die gekrümmte Anzeigefläche (232) bildet, eine Pixelanordnung umfasst, die eine Mehrzahl von Pixeleinheiten umfasst, wobei jeweils zwei benachbarte Pixeleinheiten (110) durch eine Verbindungsstruktur (120) verbunden sind; und wobei die Verbindungsstruktur (120) konfiguriert ist, zu ermöglichen, dass ein Abstand zwischen den jeweils zwei benachbarten Pixeleinheiten (110) auf eine erforderliche Verbindungslänge vergrößert oder verkleinert wird, wenn die Pixelanordnung gebogen wird, und ferner konfiguriert ist, ein Ansteuersignal zum Ansteuern der Lichtemission der Pixeleinheiten zu übertragen,
wobei die flache Anzeigefläche (231) eine Pixelanordnung umfasst, die eine Mehrzahl von Pixeleinheiten umfasst, wobei eine Verbindungsleitung zum Verbinden jeweils zweier benachbarter Pixeleinheiten (110) in der flachen Anzeigefläche (231) als gerade Linie vorgesehen ist und ferner konfiguriert ist, ein Ansteuersignal zum Ansteuern der Lichtemission der Pixeleinheiten zu übertragen, und
wobei das Anzeigemodul ferner Verkapselungsschichten umfasst, die konfiguriert sind, die Pixeleinheiten zu schützen,
**dadurch gekennzeichnet, dass**
die Anzeigekomponente einen ersten Bereich und einen zweiten Bereich umfasst, wobei der erste Bereich ein größeres Ausmaß an Verformung aufweist als der zweite Bereich,
wobei eine erste Anzahl benachbarter Pixeleinheiten in derselben Verkapselungsschicht in dem ersten Bereich verkapselt ist und eine zweite Anzahl benachbarter Pixeleinheiten in derselben Verkapselungsschicht in dem zweiten Bereich verkapselt ist,
wobei die erste Anzahl kleiner ist als die zweite Anzahl.

2. Das Anzeigemodul (230) nach Anspruch 1, wobei
die Verbindungsstruktur (120) ein elastisches geradliniges Segment ist; oder
die Verbindungsstruktur (120) eine gekrümmte Verbindungsleitung ist.

3. Das Anzeigemodul (230) nach Anspruch 2, wobei
die gekrümmte Verbindungsleitung ein oder mehrere hintereinander verbundene S-förmige Leitungssegmente umfasst; oder
die gekrümmte Verbindungsleitung eine Wellenlinie ist.

4. Das Anzeigemodul (230) nach Anspruch 2 oder 3, wobei eine Länge der gekrümmten Verbindungsleitung ein vorbestimmtes Vielfaches des Abstands zwischen den jeweils zwei benachbarten Pixeleinheiten (110) ist.

5. Das Anzeigemodul (230) nach einem der Ansprüche 1 bis 4, ferner umfassend ein flexibles Substrat;
wobei das flexible Substrat konfiguriert ist, die Pixelanordnung zu tragen, wobei die Pixeleinheiten zwischen dem flexiblen Substrat und den Verkapselungsschichten angeordnet sind.

6. Das Anzeigemodul (230) nach einem der Ansprüche 1 bis 5, wobei
ein Substrat der gekrümmten Anzeigefläche ein flexibles Substrat ist und ein Substrat der flachen Anzeigefläche ein starres Substrat ist; oder
Substrate der flachen Anzeigefläche und der gekrümmten Anzeigefläche beide flexible Substrate sind.

7. Ein Verfahren zum Herstellen des Anzeigemoduls nach einem der Ansprüche 1 bis 6, wobei das Verfahren umfasst:
Ausbilden (S100) einer Pixelanordnung, die eine Mehrzahl von Pixeleinheiten umfasst;
Ausbilden von Verkapselungsschichten der Mehrzahl von Pixeleinheiten in der gekrümmten Anzeigefläche; und
Ausbilden (S110) einer Verbindungsleitung zum Verbinden jeweils zweier benachbarter Pixeleinheiten; wobei die Verbindungsleitung konfiguriert ist, ein Ansteuersignal zum Ansteuern der Lichtemission der Pixeleinheiten zu übertragen; wobei die Verbindungsleitung in der gekrümmten Anzeigefläche des Anzeigemoduls die Verbindungsstruktur ist, die konfiguriert ist, zu ermöglichen, dass der Abstand zwischen den beiden Pixeleinheiten auf die erforderliche Verbindungslänge vergrößert oder verkleinert wird, wenn die Pixelanordnung gebogen wird; und wobei die Verbindungsleitung in der flachen Anzeigefläche des Anzeigemoduls eine gerade Linie ist,
**dadurch gekennzeichnet, dass**
das Ausbilden der Verkapselungsschichten der Mehrzahl von Pixeleinheiten in der gekrümmten Anzeigefläche umfasst:
Verkapseln einer ersten Anzahl benachbarter Pixeleinheiten der Anzeigekomponente in derselben Verkapselungsschicht in einem ersten Bereich und Verkapseln einer zweiten Anzahl benachbarter Pixeleinheiten der Anzeigekomponente in derselben Verkapselungsschicht in einem zweiten Bereich, wobei der erste Bereich ein größeres Ausmaß an Verformung aufweist als der zweite Bereich und die erste Anzahl kleiner ist als die zweite Anzahl.

8. Das Verfahren nach Anspruch 7, ferner umfassend:
Ausbilden einer Sperrschicht, die die Pixelanordnung, die gerade Linie und die Verbindungsstruktur bedeckt; und
Ätzen der Sperrschicht gemäß einem vordefinierten Muster, um eine gleichmäßige Verkapselungsschicht der flachen Anzeigefläche auszubilden.

9. Das Verfahren nach Anspruch 7 oder 8, wobei das Ausbilden der Pixelanordnung, die die Mehrzahl von Pixeleinheiten umfasst, umfasst:
Ausbilden der Pixelanordnung, die eine Mehrzahl organischer Leuchtdioden umfasst.

10. Eine elektronische Vorrichtung (200), umfassend ein Gehäuse, ein Verarbeitungsmodul und das Anzeigemodul nach einem der Ansprüche 1 bis 6;
wobei das Verarbeitungsmodul in dem Gehäuse angeordnet ist und konfiguriert ist, ein Ansteuersignal zu erzeugen; und
wobei das Anzeigemodul konfiguriert ist, entsprechend dem Ansteuersignal eine Anzeige durchzuführen.

11. Die elektronische Vorrichtung nach Anspruch 10, wobei
die flache Anzeigefläche des Anzeigemoduls eine Anzeigefläche umfasst, die auf einer ersten Oberfläche der elektronischen Vorrichtung angeordnet ist; und
die gekrümmte Anzeigefläche des Anzeigemoduls eine Anzeigefläche umfasst, die auf einer zweiten Oberfläche der elektronischen Vorrichtung angeordnet ist, wobei die zweite Oberfläche eine benachbarte Oberfläche der ersten Oberfläche ist und die zweite Oberfläche eine gewölbte Oberfläche ist.

## Revendications

1. Un module d'affichage (230), comprenant :
une zone d'affichage plane (231) et une zone d'affichage courbe (232) ;
dans lequel un composant d'affichage (100) constituant la zone d'affichage courbe (232) comprend un réseau de pixels comprenant une pluralité d'unités de pixels, dans lequel deux unités de pixels adjacentes quelconques (110) sont reliées par une structure de liaison (120) ; et la structure de liaison (120) étant configurée pour permettre à une distance entre les deux unités de pixels adjacentes quelconques (110) d'être augmentée ou diminuée jusqu'à une longueur de connexion requise lorsque le réseau de pixels est courbé, et étant en outre configurée pour transmettre un signal de pilotage destiné à piloter l'émission de lumière par les unités de pixels,
la zone d'affichage plane (231) comprend un réseau de pixels comprenant une pluralité d'unités de pixels, dans lequel une ligne de liaison destinée à relier deux unités de pixels (110) adjacentes quelconques dans la zone d'affichage plane (231) est prévue sous forme d'une ligne droite, et étant en outre configurée pour transmettre un signal de pilotage destiné à piloter l'émission de lumière par les unités de pixels, et
le module d'affichage comprend en outre des couches d'encapsulation configurées pour protéger les unités de pixels,
**caractérisé en ce que**,
le composant d'affichage comprend une première zone et une deuxième zone, la première zone présentant un degré de déformation supérieur à celui de la deuxième zone,
dans lequel un premier nombre d'unités de pixels adjacentes sont encapsulées dans une même couche d'encapsulation dans la première zone, et un deuxième nombre d'unités de pixels adjacentes sont encapsulées dans une même couche d'encapsulation dans la deuxième zone,
dans lequel le premier nombre est inférieur au deuxième nombre.

2. . Le module d'affichage (230) de la revendication 1, dans lequel
la structure de liaison (120) est un segment de ligne droite élastique ; ou,
la structure de liaison (120) est une ligne de liaison courbe.

3. . Le module d'affichage (230) de la revendication 2, dans lequel
la ligne de liaison courbe comprend un ou plusieurs segments de ligne en forme de S reliés de manière séquentielle ; ou,
la ligne de liaison courbe est une ligne ondulée.

4. . Le module d'affichage (230) de la revendication 2 ou 3, dans lequel une longueur de la ligne de liaison courbe est un multiple prédéterminé de la distance entre les deux unités de pixels adjacentes quelconques (110).

5. . Le module d'affichage (230) de l'une quelconque des revendications 1 à 4, comprenant en outre un substrat flexible ;
le substrat flexible étant configuré pour supporter le réseau de pixels, dans lequel les unités de pixels sont disposées entre le substrat flexible et les couches d'encapsulation.

6. . Le module d'affichage (230) de l'une quelconque des revendications 1 à 5, dans lequel
un substrat de la zone d'affichage courbe est un substrat flexible, et un substrat de la zone d'affichage plane est un substrat rigide ; ou,
des substrats de la zone d'affichage plane et de la zone d'affichage courbe sont tous deux des substrats flexibles.

7. . Un procédé de fabrication du module d'affichage selon l'une quelconque des revendications 1 à 6, le procédé comprenant :
la formation (S100) d'un réseau de pixels comprenant une pluralité d'unités de pixels ;
la formation de couches d'encapsulation de la pluralité d'unités de pixels dans la zone d'affichage courbe ; et
la formation (S110) d'une ligne de liaison destinée à relier deux unités de pixels adjacentes quelconques ; dans lequel la ligne de liaison est configurée pour transmettre un signal de pilotage destiné à piloter l'émission de lumière par les unités de pixels ; la ligne de liaison dans la zone d'affichage courbe du module d'affichage étant la structure de liaison configurée pour permettre à la distance entre les deux unités de pixels quelconques d'être augmentée ou diminuée jusqu'à la longueur de connexion requise lorsque le réseau de pixels est courbé ; et la ligne de liaison dans la zone d'affichage plane du module d'affichage étant une ligne droite,
**caractérisé en ce que**,
la formation des couches d'encapsulation de la pluralité d'unités de pixels dans la zone d'affichage courbe comprend :
l'encapsulation d'un premier nombre d'unités de pixels adjacentes du composant d'affichage dans une même couche d'encapsulation dans une première zone, et l'encapsulation d'un deuxième nombre d'unités de pixels adjacentes du composant d'affichage dans une même couche d'encapsulation dans une deuxième zone, la première zone présentant un degré de déformation supérieur à celui de la deuxième zone, le premier nombre étant inférieur au deuxième nombre.

8. . Le procédé de la revendication 7, comprenant en outre :
la formation d'une couche de barrière recouvrant le réseau de pixels, la ligne droite et la structure de liaison ; et
la gravure de la couche de barrière selon un motif prédéfini pour former une couche d'encapsulation uniforme de la zone d'affichage plane.

9. . Le procédé de la revendication 7 ou 8, dans lequel la formation du réseau de pixels comprenant la pluralité d'unités de pixels comprend :
la formation du réseau de pixels comprenant une pluralité de diodes électroluminescentes organiques.

10. . Un dispositif électronique (200), comprenant un boîtier, un module de traitement et le module d'affichage selon l'une quelconque des revendications 1 à 6 ;
le module de traitement étant disposé dans le boîtier et étant configuré pour générer un signal de pilotage ; et
le module d'affichage étant configuré pour effectuer un affichage selon le signal de pilotage.

11. . Le dispositif électronique de la revendication 10, dans lequel
la zone d'affichage plane du module d'affichage comprend une zone d'affichage disposée sur une première surface du dispositif électronique ; et
la zone d'affichage courbe du module d'affichage comprend une zone d'affichage disposée sur une deuxième surface du dispositif électronique, dans lequel la deuxième surface est une surface adjacente à la première surface et la deuxième surface est une surface bombée.
